(19)

Europäisches Patentamt

European Patent Office

Office européen des brevets

(11) **EP 2 767 561 A1**

(12) **EUROPEAN PATENT APPLICATION**

(43) Date of publication:
20.08.2014 Bulletin 2014/34

(51) Int Cl.:
*C08L 83/14* *(2006.01)*

(21) Application number: 14155546.6

(22) Date of filing: 18.02.2014

(84) Designated Contracting States:
AL AT BE BG CH CY CZ DE DK EE ES FI FR GB
GR HR HU IE IS IT LI LT LU LV MC MK MT NL NO
PL PT RO RS SE SI SK SM TR
Designated Extension States:
BA ME

(30) Priority: 18.02.2013  TW 102105534
15.07.2013  TW 102125255

(71) Applicant: CSI Chemical Company Limited
New Taipei City 235 (TW)

(72) Inventors:
• **Huang, Chih Wei**
**235 New Taipei City (TW)**
• **Ke, Song**
**235 New Taipei City (TW)**

(74) Representative: **Baldwin, Mark et al**
**Firebird IP**
**40 Bowling Green Lane**
**London EC1R 0NE (GB)**

(54) **LED device, polysiloxane compound and base formula for LED devices**

(57)    A polysiloxane compound for LED device includes (A) cage-shaped, mesh-shaped or chain-shaped polysiloxane containing alkenyl groups, (B) polysiloxane containing Si-H bonds, (C) a filler composition with a protective function, and (D) a catalyst with ene hydrogen silylation reaction. The filler composition with a protective function is selected from the group of high thermal conductivity material, flame retardant, anti-aging material, UV-resistant material, gas-barrier material, thermal expansion suppression material and/or high temperature-resistant material that are suitable for use in the base, lamp cup and/or encapsulation body of the LED device to effectively improves the lifespan and operational stability of the LED device.

FIG.1

EP 2 767 561 A1

## Description

The present invention relates to LED technology and more particularly, to a polysiloxane compound for LED devices, a material formula for the base, lamp cup and/or package of an LED device, and an LED device.

In the development of LED lighting technology, many manufacturers or scholars, aiming at material properties, have created materials for LED devices that effectively enhance LED operational stability or lifespan. Exemplars are seen in Taiwan Patent I373478 "Thermosetting resin composition, LED package and its fabrication method, and optical semiconductor"; US7,615,387 "Addition curing silicone composition capable of producing a cured product with excellent crack resistance" and US 7,705,104 "Addition curable silicon resin composition for light emitting diode".

The former material research and development studies are generally focused on the LED encapsulation body; few of them are focused on the base, substrate and/or lamp cup for an LED. Siloxane-based materials are commonly used in new materials for LED encapsulation body. However, siloxane-based materials are usually very difficult to bond satisfactorily with other material groups.

Further, in an LED device, the encapsulation body and the base are normally made from different materials that differ in cold and hot weather shrinkage. Therefore, the problem of component detachment or cracked adhesive can occur in an LED device using the aforesaid prior art base or lamp cup formula due to insecure bonding or shrinkage differential when it is used in a high temperature and high humidity environment. This affects the operational stability and lifespan of the LED device.

## SUMMARY OF THE INVENTION

It is, therefore, the main object of the invention to provide a polysiloxane compound for LED devices, a material formula for the base, lamp cup and/or package or encapsulation body of an LED device and an LED device that at least partially mitigates the drawbacks of prior art material formulas for LED devices to enhance LED device operational stability and prolong LED life span, or to provide an alternative to existing products or methodology.

The invention provides a polysiloxane compound for LED device application, comprising: (A) Cage shaped, mesh shaped or chain shaped polysiloxane containing alkenyl groups, having the overall average composition as indicated in the following structural formula (1): $R^1_n SiO_{(4-n)/2}$ (1); (B) Si-H bond contained polysiloxane, having the overall average composition as indicated in the following structural formula (2): $R^3_a H_b SiO_{(4-a-b)/2}$ (2); (C) Filler composition having a protective function; and (D) Catalyst with ene hydrogen silylation reaction.

The invention also includes a base formula for LED device comprising a polysiloxane compound.

The invention also includes a base formula for LED devices.

The invention also includes an LED device comprising a base, wherein said base is made from a polysiloxane compound.

In some embodiments of the polysiloxane compound, the range of n in said structural formula (1) in the composition (A) is within 1 to 2.

In some embodiments of the polysiloxane compound, said filler composition is selected from the group of high thermal conductivity materials, flame retardants, anti-aging materials, UV-resistant materials, high temperature-resistant materials, gas-barrier materials, thermal expansion suppression materials, and their combinations.

In some embodiments of the polysiloxane compound, said filler composition is selected from the group of silicon nitride, silicon carbide, aluminium hydroxide, organic chlorides, organic bromides, red phosphorus, phosphate esters, halogenated phosphate esters, nitrogenated flame retardants, organic halogen monomers, organic phosphorus monomers, silica, metal oxides, calcium carbonate, carbon nanotube, carbon nano-fibres, graphene, boron nitride, metal nitrides, carbon fibres, graphite, diamond, carbon, ceramics, nano mica, antiperovskite manganese nitrogen compounds, and their combinations.

In some embodiments of the polysiloxane compound, said Si-H bond contained polysiloxane of the composition (B) is a cage shaped, mesh shaped or chain shaped polysiloxane containing hydrosilyl group; the content of said cage shaped, mesh shaped or chain shaped polysiloxane containing alkenyl groups of the composition (A) is in the range of 1~99wt%; the content of said hydrosilyl group contained polysiloxane of the composition (B) is in the range of 1~40wt%; the content of filler composition having a protective function of the composition (C) is in the range of 1~90wt%; the content of said catalyst with ene hydrogen silylation reaction of the composition (D) is effective catalytic amount up to 500 weight ppm, based on the overall weight of polysiloxane.

In some embodiments of the polysiloxane compound, the content of said catalyst with ene hydrogen silylation reaction in the composition (D) is preferably within the range of 1~50ppm.

In some embodiments of the polysiloxane compound, said catalyst with ene hydrogen silylation reaction in the composition (D) is selected from the group of platinum-based catalysts, palladium-based catalysts and rhodium-based catalysts.

In some embodiments of an LED device, said base comprises a substrate and/or a lamp cup.

In some embodiments of an LED device, the LED device further comprises an encapsulation body made from a polysiloxane compound.

BRIEF DESCRIPTION OF THE DRAWINGS

Fig. 1 is a schematic sectional structural view of an LED device in accordance with a first embodiment of the invention.
Fig. 2 is a schematic sectional structural view of an LED device in accordance with a second embodiment of the invention.

DETAILED DESCRIPTION OF EMBODIMENTS

A polysiloxane compound for an LED device application according to the invention may comprise:

(A) Cage shaped, mesh shaped or chain shaped polysiloxane containing alkenyl groups, having the overall average composition as indicated in the following structural formula (1):

$$R^1{}_n SiO_{(4-n)/2} \qquad (1);$$

in which:

$R^1$ is an independent monovalent hydrocarbyl group, alkoxy group or hydroxyl group with or without a substituent selected from the group of halo, alkyl, cycloalkyl, aryl;
n is a positive number; and

$$0 \leqq n \leqq 2.$$

The thermoformable polysiloxane and filler composition with protective function in accordance with the invention may comprise:

(B) Si-H bonds-contained polysiloxane of overall average composition as indicated by structural formula (2):

$$R^3{}_a H_b SiO_{(4-a-b)/2} \qquad (2)$$

in which:

$R^3$ is an independent monovalent hydrocarbyl group, alkoxy group or hydroxyl group, excluding alkenyl group with or without a substituent selected from the group of halo, alkyl, cycloalkyl, aryl and alkoxy; and
a and b are positive numbers.
The thermoformable polysiloxane and filler composition with protective function in accordance with the invention can have the following composition added thereto:

(C) a filler material with protective function containing high thermal conductivity material, flame retardant, anti-aging material, UV-resistant material, high temperature-resistant material, gas-barrier material, thermal expansion suppression material (Thermal Expansion Inhibitor) and their combinations, for example, selected from the group of silicon nitride ($Si_3N_4$), silicon carbide (SiC), aluminium hydroxide ($Al(OH)_3$), organic chlorides, organic bromides, red phosphorus, phosphate esters, halogenated phosphate esters, nitrogenated flame retardant, organic halogen monomer, organic phosphorus monomer, silica ($SiO_2$), metal oxides, calcium carbonate, carbon nanotube (Carbon Nanotube), carbon nano-fibres (Nano Fibre), graphene (Graphene), boron nitride, metal nitrides, carbon fibres, graphite, diamond, carbon, ceramics, nano mica (Nano Mica), antiperovskite manganese nitrogen compounds (Anti-Perovskite Structure Mn3XN (X=Ge, Zn, Sn, Cu, Ge) and their combinations. The metal oxides are preferably selected from, but not limited to, the group of aluminium oxide ($Al_2O_3$), chromium trioxide ($Cr_2O_3$), zinc peroxide ($ZnO_2$) and titanium dioxide ($TiO_2$). The metal nitrides is preferably, but not limited to, aluminium nitride.
In some embodiments of the invention, the amount of silicon carbide (SiC) of the composition is in the range of 2wt%~20wt%; the amount of aluminium oxide ($Al_2O_3$) is in the range of 10wt%~100wr%; the amount of aluminium

hydroxide (Al(OH)$_3$) is in the range of 5wt%~50wt%; the amount of zinc peroxide (ZnO$_2$) is in the range of 1wt%~10wt%; the amount of titanium dioxide (TiO$_2$) is in the range of 1wt%~10wt%; the amount of flame retardant is in the range of 5wt%~80wt%.

The thermoformable polysiloxane and filler composition with protective function can have the following composition added thereto:

(D) Catalyst with ene hydrogen silylation reaction selected from platinum-based, palladium-based or rhodium-based catalysts, or their combinations.

There is no special limited to the content of the catalyst of the composition (D). Normally, any effective catalytic amount can be accepted. Based on the total weight of polysiloxane as a reference, the amount of the catalyst of the composition (D) can be 500ppm maximum, or preferably in the range of 0.1~100ppm, or most preferably in the range of 1~50ppm.

The thermoformable polysiloxane and filler composition with protective function of the invention are suitable for use in the fabrication of a base (substrate and/or lamp cup) and/or encapsulation body for LED device.

The invention may provide a formula for the base (substrate and/or lamp cup) for an LED device that comprises the thermoformable polysiloxane and filler composition with protective function prepared according to the invention.

The advantages and features of the invention will be fully understood by reference to the following detailed in conjunction with the accompanying drawings. In the presently preferred embodiments: A represents case-shaped, mesh-shaped or chain-shaped polysiloxane containing alkenyl groups; B represents Si-H bond contained polysiloxane; C represents filler composition having a protective function that contains high thermal conductivity material, flame retardant, anti-aging material, UV-resistant material, high temperature-resistant material or their combinations; and D represents catalyst with ene hydrogen silylation reaction.

In some embodiments of the invention, B is preferably cage-shaped, mesh-shaped or chain-shaped polysiloxane containing Si-H bonds. However, this is not a limitation.

[Preparation of test samples]

(1) Fill formulated material for a base or a lamp cup in a mating mould and then heat the mould to cure the applied material and then open the mould to take out the cured material for application; and

(2) Prepare an encapsulation adhesive selected from the same material group and then fill the encapsulation adhesive into the lamp cup (or rack) obtained in step (I), and then enable the lamp cup (or rack) with the filled encapsulation adhesive to be thermally cross-linked and cured at 60°C for 1 hour or 120°C for 2 hours, thereby obtaining a test sample.

[Characteristic Assessment]

(1). Red ink test

Dip the encapsulated and cured LED device sample in a red ink supplied by Merck, and then heat the red ink to 80°C for 24 hours, and then pick up the LED device from the red ink, and then wash the LED device sample with clean water, and then wipe dry the LED device sample, and then use an optical microscope to observe whether or not the red ink permeates into the LED device sample.

O: No red ink permeation is observed under the microscope.

X: Red ink permeation is observed under the microscope.

(2). Reflow test

Reflow the encapsulated and cured LED device sample at 260°C three minutes each time and totally 20 times, and then observe the LED device sample with an optical microscope.

O: Neither cracked adhesive, bubbles in adhesive, peeling of bonding surface of the encapsulated and cured LED lamp cup, nor bubbles in bonding surface of the encapsulated and cured LED lamp cup is observed under the microscope.

X: Cracked adhesive, bubbles in adhesive, peeling of bonding surface of the encapsulated and cured LED lamp cup, or bubbles in bonding surface of the encapsulated and cured LED lamp cup are observed under the microscope.

(3). Temperature cycling test

Put the encapsulated and cured LED device sample under the environment of 85°C/85% relative humidity for 160 hours, and then enable the sample to be heated to 120°C for 30 minutes and cooled at -40°C for 30 minutes and totally in 1000 cycles, and then observe the LED device sample with an optical microscope.
O: Neither cracked adhesive, bubbles in adhesive, peeling of bonding surface of the encapsulated and cured LED lamp cup, nor bubbles in bonding surface of the encapsulated and cured LED lamp cup is observed under the microscope.
X: Cracked adhesive, bubbles in adhesive, peeling of bonding surface of the encapsulated and cured LED lamp cup, or bubbles in bonding surface of the encapsulated and cured LED lamp cup are observed under the microscope.

[Example of synthesis]

An example of the synthesis of the material formula of the thermoformable polysiloxane and filler composition with protective function for making a base (substrate and/or lamp cup) for LED device is described below:

(A) cage-shaped, mesh-shaped or chain-shaped polysiloxane containing alkenyl groups

Take 30% aqueous hydrochloric acid 100g and add it to a reaction flask, and then add 400g ethanol and methyl phenyl dimethoxy silane 50g, vinyl trimethoxy silane 30g, phenyl trimethoxy silane 306g, diphenyl dimethoxy silane 60g and hexamethyl siloxane 15g to obtain a reaction mixture.
Thereafter, enable the reaction mixture to be reacted at 40~90°C for 2-6 hours, and then wash the reacted substance with water to neutral, then remove solvent from the substance under reduced pressure.
Thereafter, add 5g concentrated sulphuric acid ($H_2SO_4$) to the substance thus obtained, and then process the substance through a series of decompression, heating, dehydration and neutralization processes, and then wash it with water to neutral, and then dehydrate the substance by decompression, thereby obtaining 100g cage-shaped, mesh-shaped or chain-shaped, alkenyl group-contained polysiloxane.

(B) polysiloxane containing Si-H bonds

Take 30% aqueous hydrochloric acid 100g and put it in a reaction flask, and then add 400g ethanol and methyl phenyl dimethoxy silane 50g, tetrahydro dimethyl siloxane 50g, phenyl trimethoxy silane 250g, diphenyl dimethoxy silane 40g and hexamethyl siloxane 10g to obtain a reaction mixture.
Thereafter, enable the reaction mixture to be reacted at 40~90°C for 2-6 hours, and then wash the reacted mixture with clean water to neutral, and then remove solvent from the substance thus obtained by decompression.
Thereafter, add 5g concentrated sulphuric acid ($H_2SO_4$) to the substance thus obtained, and then process the substance through a series of decompression, heating, dehydration and neutralization processes, and then wash it with water to neutral, and then dehydrate the substance by decompression, thereby obtaining 100g Si-H bond-contained polysiloxane.

(C) filler materials having a protective function that contains high thermal conductivity material, flame retardant, anti-aging material, UV-resistant material, high temperature-resistant material or their combination

Mix 5g of $S_iC$, 50g of $Al_2O_3$, 30g of $Al(OH)_3$, 2g of $ZnO_2$, 5g of $TiO_2$ and 30g of flame retardant, and then put the mixture in a rotary evaporator furnace to remove water.

(D) ene hydrogen silylation reaction catalyst

The catalyst may be selected from the group of platinum family, palladium family, rhodium family and their combinations.

(Example 1)

Take:

(A) 88 grams of cage-shaped, mesh-shaped or chain-shaped polysiloxane containing alkenyl groups;

(B) 10 grams of polysiloxane containing Si-H groups that is a cage-shaped, mesh-shaped or chain-shaped polysiloxane containing hydrosilyl group;

(C) 200 grams of a filler composition having a protective function selected from the group of high thermal conductivity material, flame retardant, anti-aging material, UV-resistant material, high temperature-resistant material and their combinations; and

(D) 50ppm of catalyst containing alkenyl groups with ene hydrogen silylation reaction.

And then, thoroughly mix the selected materials and treat them through a vacuum deaeration process to obtain formulated materials for making the base (substrate and/or lamp cup).

(Examples 2 to 6)

Prepare formula examples for base (substrate and/or lamp cup) by means of mixing and vacuum deaeration procedures subject to the composition and weight (g) listed in the following Table 1:

(Table 1)

| Formulated Composition | Ex. 1 | Ex. 2 | Ex. 3 | Ex. 4 | Ex. 5 | Ex. 6 | Com.Ex. 1 | Com.Ex. 2 |
|---|---|---|---|---|---|---|---|---|
| (A)-(g) | 88 | 100 | 100 | 100 | 100 | 100 | | |
| (B)-(g) | 10 | 10 | 15 | 5 | 10 | 15 | | |
| (C)-(g) | 200 | 100 | 200 | 200 | 400 | 300 | | |
| (D)-(ppm) | 50 | 50 | 100 | 100 | 50 | 200 | | |
| Red ink test (80°C/24h) | ○ | ○ | ○ | ○ | ○ | ○ | X | X |
| Reflow teat (260°C/3min, 20 times) | ○ | ○ | ○ | ○ | ○ | ○ | X | X |
| Temp. Cycling Test (-40°C/120°C, 1000 times) | ○ | ○ | ○ | ○ | ○ | ○ | X | X |

The above-said formulated compositions 1 to 6 for base (substrate and/or lamp cup) were used to make test samples for comparison with the comparative samples 1 (polyphthal amide lamp cup) and 2 (epoxy lamp cup) through red ink test, reflow test and temperature cycling test (-40°C/120°C), and thus characterisits assessment results were obtained as indicated in Table 1.

In Table 1, an LED base (substrate or lamp cup) made from the thermoformable polysiloxane compound of the present invention with an encapsulation body subject to Examples 1 to 6 are commonly based on polysiloxane and added with at least one filler composition with protective function. When cured to form an LED rack or lamp cup and then encapsulated with the same siloxane material, and then observed under an optical microscope, no red ink permeation was found. Further, after through reflow test and temperature cycling test (tested under the condition of -40 °C/120°C), no any stripping or peeling condition was observed.

In contrast, the comparative sample 1 (PPA lamp cup) and 2 (Epoxy lamp cup) without containing the thermoformable polysiloxane compound of the invention exhibited poor quality results in red ink test, reflow test and temperature cycling test.

It is understood that the thermoformable polysiloxane and filler composition with protective function in accordance with the invention enables an LED rack, base, substrate or lamp cup to have the same hot and cold shrinkage relative to the encapsulation adhesive of the same material group, exhibiting excellent demoulding, desorption, thermo shock resistance characteristics. Further, the thermoformable polysiloxane and filler composition with protective function is practical for hot extrusion moulding and suitable for the fabrication of an LED base (substrate and/or lamp cup) as well as other commercial applications, facilitating LED base fabrication.

[LED device preparation]

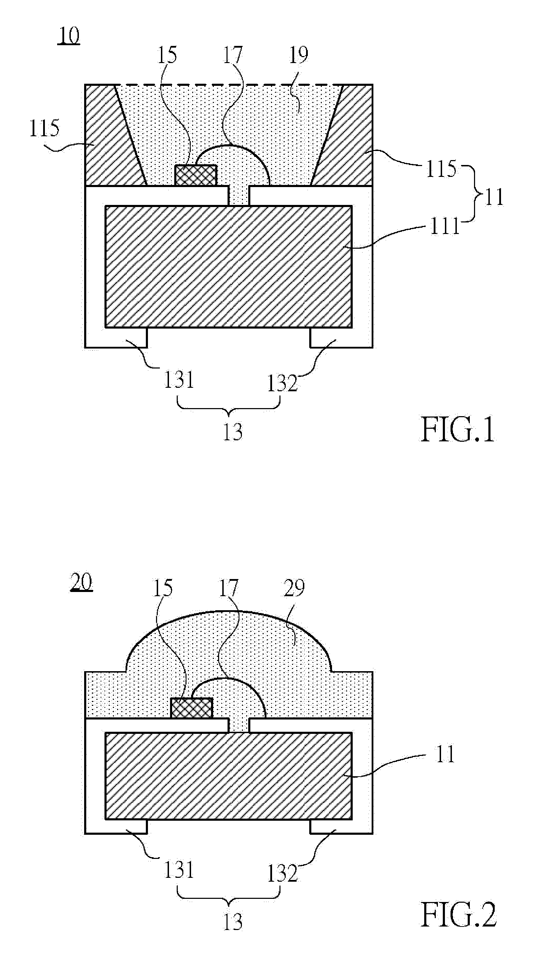

Referring to FIG. 1, an LED device **10** based on the aforesaid polysiloxane and filler composition having a protective function is shown. As illustrated, the LED device **10** is a surface mount device type LED device, also known as chip type LED device or planar LED device, comprising a substrate **111,** a plurality of lead frames **13,** for example, a first lead frame **131** and a second lead frame **132** separately mounted at the substrate **111,** an LED **15** fixedly mounted at the first lead frame **131,** and a lead wire **17** electrically connecting the LED **15** to the second lead frame **132** such that the first lead frame **131,** the LED **15,** the lead wire **17** and the second lead frame **132** constitute a conductive path.

The LED device **10** further comprises a lamp cup (also known as an annular body) **115** mounted around the border area of the lead frames **13** and defining with the substrate **111** and the lead frames **13** an open space. The LED **15** may be mounted in the open space surrounded by the lamp cup **115.** The substrate **111,** lamp cup 115, the lead frames **13** and an encapsulation body **19** that is moulded in the open space protect the LED **15.**

The polysiloxane compound (containing a filler composition having a protective function) is applicable to the fabrication of the base **11** for the LED device **10.** That is it can be used for making the substrate **111** and/or lamp cup **115** of the base **11** of the LED device **10.**

In a first embodiment of the invention, the substrate **111** and lamp cup **115** of the base **11** of the LED device **10** and the encapsulation body **19** are made from the same or similar polysiloxane compound. Thus, the material properties or chemical properties of these components are relatively close to one another, providing better adhesion and crashworthiness.

Further, if the encapsulation body **19** of the LED device **10** is made from a different material relative to the substrate **111** and/or lamp cup **115** of the base **11** to meet a different luminosity requirement, the polysiloxane compound (containing a filler composition having a protective function) enables the the substrate **111** and/or lamp cup **115** of the base **11** to have better protective properties of thermal conductivity, flame retardancy, aging resistance, UV resistance and/or high temperature, assuring high operational stability and prolonging the lifespan of the LED device **10.**

In a second embodiment of the invention, as shown in FIG. 2, the LED device **20,** is a lens type or convex type LED device. This second embodiment is substantially similar to the first embodiment shown in FIG. 1 with the exception that the base **11** is formed of a substrate **111** without the aforesaid lamp cup **115,** and the encapsulation body **29,** is made in the form of a convex (or concave) lens.

In similar fashion to the first embodiment, the base **11** and/or the encapsulation body **29** can also be made from the aforesaid polysiloxane compound (containing a filler composition having a protective function), enhancing the operational stability of the LED device **20** and prolonging its lifespan.

Although particular embodiments of the invention have been described in detail for purposes of illustration, various modifications and enhancements may be made without departing from the scope of the invention. For example, the single quantifier (such as one or the) described in the specification can also be multiple unless otherwise specifically defined, i.e., one member can be a combination of two or more components, and one substance can be a combination of multiple substances. Accordingly, the invention is not to be limited except as by the appended claims.

**Claims**

1. A polysiloxane compound for LED device application, comprising:

    (A) Cage shaped, mesh shaped or chain shaped polysiloxane containing alkenyl groups, having the overall average composition as indicated in the following structural formula (1):

    $$R^1_n SiO_{(4-n)/2} \qquad (1);$$

    (B) Si-H bond contained polysiloxane, having the overall average composition as indicated in the following structural formula (2):

    $$R^3_a H_b SiO_{(4-a-b)/2} \qquad (2);$$

    (C) Filler composition having a protective function; and
    (D) Catalyst with ene hydrogen silylation reaction.

2. The polysiloxane compound as claimed in claim 1, wherein the range of n in said structural formula (1) in the composition (A) is in 1 to 2.

3. The polysiloxane compound as claimed in claim 1 or 2, wherein said filler composition is one, or a combination, of high thermal conductivity materials, flame retardants, anti-aging materials, UV-resistant materials, high temperature-resistant materials, gas-barrier materials, thermal expansion suppression materials.

4. The polysiloxane compound as claimed in claim 3, wherein said filler composition is one, or a combination, of silicon nitride, silicon carbide, aluminium hydroxide, organic chlorides, organic bromides, red phosphorus, phosphate esters, halogenated phosphate esters, nitrogenated flame retardants, organic halogen monomers, organic phosphorus monomers, silica, metal oxides,

calcium carbonate, carbon nanotube, carbon nano-fibres, graphene, boron nitride, metal nitrides, carbon fibres, graphite, diamond, carbon, ceramics, nano mica, antiperovskite manganese nitrogen compounds.

5. The polysiloxane compound as claimed in any one of the preceding claims, wherein said Si-H bond contained polysiloxane of the composition (B) is a cage shaped, mesh shaped or chain shaped polysiloxane containing hydrosilyl group; the content of said cage shaped, mesh shaped or chain shaped polysiloxane containing alkenyl groups of the composition (A) is in the range of 1 to 99wt%; the content of said hydrosilyl group contained polysiloxane of the composition (B) is in the range of 1 to 40wt%; the content of filler composition having a protective function of the composition (C) is in the range of 1 to 90wt%; the content of said catalyst with ene hydrogen silylation reaction of the composition (D) is effective catalytic amount up to 500 weight ppm, based on the overall weight of polysiloxane.

6. The polysiloxane compound as claimed in claim 5, wherein the content of said catalyst with ene hydrogen silylation reaction in the composition (D) is preferably in the range of 1 to 50ppm.

7. The polysiloxane compound as claimed in any one of the preceding claims, wherein said catalyst with ene hydrogen silylation reaction in the composition (D) comprises platinum-based catalysts, palladium-based catalysts or rhodium-based catalysts.

8. A base formula for LED device, comprising a polysiloxane compound as claimed in any of claims 1 to 7.

9. An LED device comprising a base, wherein said base (11) is made from a polysiloxane compound as claimed in any of claims 1 to 7.

10. An LED device as claimed in claim 9, wherein said base (11) comprises at least one of a substrate (111) and a lamp cup (115).

11. An LED device as claimed in claim 9 or 10, further comprising an encapsulation body (19) made from a polysiloxane compound as claimed in any of claims 1 to 7.

FIG.1

FIG.2

**EUROPEAN SEARCH REPORT**

Application Number

EP 14 15 5546

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | EP 1 767 580 A1 (SHINETSU CHEMICAL CO [JP]) 28 March 2007 (2007-03-28) | 1-4,6,7 | INV. C08L83/14 |
| Y | * claims 1,2,7 * <br> * table 1 * <br> * paragraph [0044] * | 11 | |
| X | EP 1 749 861 A1 (SHINETSU CHEMICAL CO [JP]) 7 February 2007 (2007-02-07) | 1-7 | |
| Y | * claims 1,10 * <br> * table 1 * <br> * paragraphs [0055] - [0056] * | 11 | |
| X | WO 2009/154260 A1 (DOW CORNING TORAY CO LTD [JP]; SAGAWA TAKASHI [JP]; TERADA MASAYOSHI [) 23 December 2009 (2009-12-23) | 1-4,6,7 | |
| Y | * examples 1,8 * <br> * example 1 * <br> * paragraph [0027] * | 11 | |
| X | WO 2011/078239 A1 (MITSUBISHI CHEM CORP [JP]; TAKASU MAYUKO; OTSU TAKESHI; TAKIZAWA KENIC) 30 June 2011 (2011-06-30) | 1,3-10 | TECHNICAL FIELDS SEARCHED (IPC) |
| Y | * example 1 * <br> * claim 1 * <br> & US 2012/286220 A1 (TAKASU MAYUKO [JP] ET AL) 15 November 2012 (2012-11-15) <br> * claim 1 * <br> * example 1 * | 11 | C08L <br> C08G <br> H01L <br> C09J |
| X | WO 2006/033375 A1 (DOW CORNING TORAY CO LTD [JP]; MORITA YOSHITSUGU [JP]; KATO TOMOKO [JP) 30 March 2006 (2006-03-30) | 1-4,6,7 | |
| Y | * examples ref. 1-3 * | 11 | |
| X | EP 2 163 585 A1 (SHINETSU CHEMICAL CO [JP]) 17 March 2010 (2010-03-17) | 1-10 | |
| Y | * claim 1 * <br> * examples 1-3 * | 11 | |

The present search report has been drawn up for all claims

| Place of search | Date of completion of the search | Examiner |
|---|---|---|
| The Hague | 31 March 2014 | Queste, Sébastien |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

**ANNEX TO THE EUROPEAN SEARCH REPORT
ON EUROPEAN PATENT APPLICATION NO.**

EP 14 15 5546

This annex lists the patent family members relating to the patent documents cited in the above-mentioned European search report.
The members are as contained in the European Patent Office EDP file on
The European Patent Office is in no way liable for these particulars which are merely given for the purpose of information.

31-03-2014

| Patent document cited in search report | | Publication date | Patent family member(s) | | Publication date |
|---|---|---|---|---|---|
| EP 1767580 | A1 | 28-03-2007 | EP | 1767580 A1 | 28-03-2007 |
| | | | JP | 4648146 B2 | 09-03-2011 |
| | | | JP | 2007084766 A | 05-04-2007 |
| | | | KR | 20070034962 A | 29-03-2007 |
| | | | TW | I398486 B | 11-06-2013 |
| | | | US | 2007073026 A1 | 29-03-2007 |
| EP 1749861 | A1 | 07-02-2007 | EP | 1749861 A1 | 07-02-2007 |
| | | | TW | I402312 B | 21-07-2013 |
| | | | US | 2007032595 A1 | 08-02-2007 |
| WO 2009154260 | A1 | 23-12-2009 | CN | 102066493 A | 18-05-2011 |
| | | | EP | 2326686 A1 | 01-06-2011 |
| | | | JP | 2010001335 A | 07-01-2010 |
| | | | KR | 20110018916 A | 24-02-2011 |
| | | | RU | 2010151565 A | 27-07-2012 |
| | | | TW | 201000561 A | 01-01-2010 |
| | | | US | 2011160410 A1 | 30-06-2011 |
| | | | WO | 2009154260 A1 | 23-12-2009 |
| WO 2011078239 | A1 | 30-06-2011 | KR | 20120114290 A | 16-10-2012 |
| | | | TW | 201130891 A | 16-09-2011 |
| | | | US | 2012286220 A1 | 15-11-2012 |
| | | | WO | 2011078239 A1 | 30-06-2011 |
| WO 2006033375 | A1 | 30-03-2006 | CN | 101027786 A | 29-08-2007 |
| | | | EP | 1812972 A1 | 01-08-2007 |
| | | | JP | 4676735 B2 | 27-04-2011 |
| | | | JP | 2006093354 A | 06-04-2006 |
| | | | KR | 20070053780 A | 25-05-2007 |
| | | | TW | I383521 B | 21-01-2013 |
| | | | US | 2008070333 A1 | 20-03-2008 |
| | | | WO | 2006033375 A1 | 30-03-2006 |
| EP 2163585 | A1 | 17-03-2010 | AT | 549377 T | 15-03-2012 |
| | | | CN | 101673716 A | 17-03-2010 |
| | | | EP | 2163585 A1 | 17-03-2010 |
| | | | JP | 2010089493 A | 22-04-2010 |
| | | | KR | 20100031080 A | 19-03-2010 |
| | | | TW | 201016458 A | 01-05-2010 |
| | | | US | 2010065880 A1 | 18-03-2010 |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- TW I373478
- US 7615387 B

- US 7705104 B